# EUROPÄISCHE PATENTSCHRIFT

(11) **EP 0 582 262 B1**
(45) Veröffentlichungstag und Bekanntmachung des Hinweises auf die Patenterteilung: **05.11.1997**
(21) Anmeldenummer: 93112377.2
(22) Anmeldetag: 03.08.1993
(51) Int. Cl.: H01L 23/055, H01L 23/13, H01L 21/60

(54) **Kontaktierung und Verkapselung von integrierten Schaltungsmodulen**
Contacting and packaging of integrated circuit modules
Connexion et empaquetage des modules à circuits integrés

(30) Priorität: 06.08.1992 DE 4226064
(43) Veröffentlichungstag der Anmeldung: 09.02.1994
(73) Patentinhaber: TEMIC TELEFUNKEN microelectronic GmbH, 74072 Heilbronn (DE)
(72) Erfinder: Nägele, Dieter, D-70794 Filderstadt (DE); Weinacht, Manfred, D-73265 Dettingen/Teck (DE); Färber, Klaus, D-73230 Kirchheim/Teck (DE)
(74) Vertreter: Maute, Hans-Jürgen, Dipl.-Ing.

(56) Entgegenhaltungen:
- WO-A-89/03999
- US-A- 4 768 070
- PATENT ABSTRACTS OF JAPAN vol. 15, no. 365 (E-1111) 13. September 1991; & JP-A-03 142 957

## Beschreibung

Die Erfindung betrifft die Kontaktierung und Verkapselung von integrierten Schaltungsmodulen, insbesondere Sensoren, deren Hauptachsen einen Winkel zueinander im Raum aufweisen, sogenannte dreidimensionale Hybride. Die Sensoren und ihre Signalverarbeitungs- und Auswerteschaltung sind dabei auf einem Chip integriert und in jeweils einem separaten Gehäuse untergebracht, vgl. die deutsche Patentschrift DE 37 36 294 C2, Fig. 3 bis 5. Solche Systeme sind nicht nur aufwendig in der Herstellung, sondern sie müssen wegen der hohen Anforderungen, insbesondere in Sicherheitssystemen in Fahrzeugen, hohen Ansprüchen an die Zuverlässigkeit genügen.

Aus der japanischen Druckschrift JP-A-3142957 ist eine Anordnung nach dem Stand der Technik für einen integrierten Schaltkreis als Dickfilmhybrid bekannt, bei der zwei Schaltkreise unter einem Winkel auf einer Wärmesenke angeordnet sind, wodurch eine große Ausgangsleistung ermöglicht wird.

Weiterhin beschreibt die Patentschrift US-A-4768070 ein optoelektronisches Bauelement, worin ein optischer Empfänger und ein Halbleiterlaser in einem hermetisch dichten Gehäuse angeordnet sind. Um auf einfache Weise eine Kontaktierung mittels Bonddraht zwischen dem Empfänger und einem Anschlußpin herstellen zu können, sind die Oberflächen des Empfängers und die des abgeflachten Anschlußpins parallel zueinander angeordnet.

Die Erfindung baut auf der vorgenannten deutschen Patentschrift DE 37 36 294 C2 auf und möchte einerseits die Zuverlässigkeit solcher Meßwerterfassungs- oder Sensormodule erhöhen, andererseits mit einem geringeren Fertigungsaufwand auskommen. Hierzu gehört ein raumsparendes und ein sicheres automatisierbares Kontaktleren und Verpacken.

Die Lösung der Erfindung ist in Anspruch 1 enthalten. Aus- und Weiterbildungen der Erfindung sind weiteren Ansprüchen sowie der Beschreibung und Zelchnung eines Ausführungsbeispiels entnehmbar.

Die wesentlichsten Vorteile der erfindungsgemäßen LÖsung bestehen darin, daß die Sensoren mit ihren Hauptachsen - hier Hauptempfindlichkeitsachsen (A1, A2) - in einer gewünschten (Fahrt-)Richtung im Raum eines Fahrzeuges als Hybrid-IC's in einem Gehäuse unterbringbar sind und zugleich mit der Verpackung alle Kontaktierungen, insbesondere durch automatisches Bonden, vornehmbar sind. Diese Kontaktierungen werden bei der Erfindung dadurch besonders erleichtert, daß die Bondflecken der Pins und die Sensormodule parallel zueinander angeordnet sind in dem gewählten Winkel im Raum bzw. 90° hierzu - vgl. die Zeichnung, die zwecks Beschreibung eines Ausführungsbeispieles beigefügt ist, ohne daß die Erfindung hierauf beschränkt ist.
- Fig. 1: zeigt einen Querschnitt durch das Gehäuse für die IC-Hybride und
- Fig. 2: zeigt den um seine 45° geneigte Mittelachse drehbaren Arbeitstisch für das Bonden.

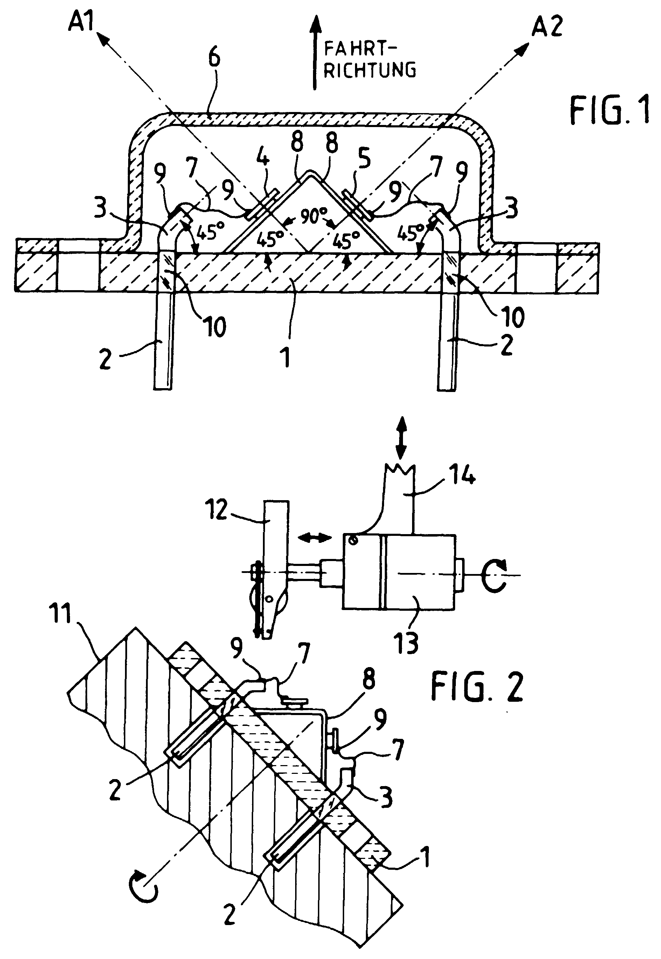

Die Fig. 1 zeigt in Einbaulage zur Fahrtrichtung den prinzipiellen Aufbau des gemeinsamen Gehäuses für die IC-Hybride 4, 5, wobei eine Grundplatte 1, mit Pins 2 durchsetzt ist, insbesondere solche mit Glasdurchführungen 10, wie sie in der integrierten Schaltungstechnik und in der Hybridtechnik üblich sind und leicht kontaktierbar sind, insbesondere durch Drahtbonden. Vor dem Einsetzen der Pins 2 in die Grundplatte 1 sind die Pins an ihren in der Zeichnung oberen Enden 3 abgekröpft um einen vorgebbaren Winkel, im Beispiel 45°, und ergeben so parallele Bondflächen zu den Sensoren in Raumrichtung 1 und zu den Sensoren (4,5) in Richtung von deren Achsen A1 und A2. Hier sind diese im Ausführungsbeispiel 90° zueinander ausgerichtet und gegenüber dem Substrat oder der Grundplatte mit 45°. Diese Winkel können bei Bedarf je nach Anwendungsfall auch hiervon abweichend gewählt werden. Die Sensoren 4, 5, welche zu den abgekröpften Enden 3 der Pins 2 parallel angeordnet sind, lassen sich bei der Erfindung in einem Arbeitsgang automatisch bonden. Dabei werden dünne Bonddrähte 7 von den IC-Hybriden mit den Sensoren 4, 5 auf ihren IC-Trägern 8 mit den Enden 3 der Pins 2 durch automatisches Bonden an den Bondflecken 9 verbunden.

Ein sehr wesentlicher Vorteil der Erfindung ist es, daß die Grundplatte 1 absolut eben ist, wenigstens auf der dem Gehäuse 6 zugekehrten Seite. Das Gehäuse, insbesondere ein Rechteckgehäuse, umfaßt nicht nur die Sensoren 4 und 5 auf ihren zueinander abgewinkelten IC-Trägern 8 sondern umhüllt auch die Pins 2, hier die abgekröpften oder abgeschrägten oder anderweitig in einem Winkel zur Grundplatte 1 angeordneten Enden 3 der Pins 2. Die absolut ebene Oberseite der Grundplatte 1 hat den Vorteil, daß hiermit eine absolut dichte Verbindung von Gehäuse und Grundplatte leicht und automatisch herstellbar ist. Die IC-Träger 8 können einfache Bleche sein, die auf der Grundplatte 1 aufgelötet, aufgeschweißt oder ähnlich fest verbunden werden unter dem gewählten Winkel.

Ein weiterer Vorteil der Erfindung ist in Fig. 2 ersichtlich, die das automatische Bonden mit Hilfe eines Roboters darstellt.

Dabei ist die Grundplatte 1 mit den IC-Hybriden 4, 5 auf ihren Trägern 8 auf dem Drehtisch 11 aufgespannt. Dieser ist ggf. auch um 45° kippbar. Die in Fig. 2 gezeigte Schräglage des Tisches 11 ist die bevorzugte Arbeitsstellung für das Bonden. Hier ist nur senkrechtes Bewegen des Bondwerkzeuges 12 nötig um mittels Druck und Wärme die Drähte 7 mit den vorher parallel zueinander aufgebrachten Bondflecken 9 zu verbinden - wie dargestellt. Das Werkzeug 12 braucht hierbei auch nur um einen vorbestimmten Abstand in der vorbestimmten Richtung (zu 14) bewegt zu werden, obwohl der Roboterkopf 13 auch Schwenken und Horizontalbewegung gestattet.

Eine Anwendung der Erfindung ist bei Beschleunigungssensoren gegeben, wie sie in der eingangs genannten deutschen Patentschrift erwähnt ist.

## Patentansprüche

1. Vorrichtung zur Verpackung von integrierten Schaltungen, enthaltend Sensoren, wobei
- in einem einzigen Gehäuse **(6)** eine ebene Grundplatte **(1)** angeordnet ist,
- durch die Grundplatte **(1)** hindurch Kontaktstifte **(2)** mit Bondflecken **(9)** zur mehrpoligen Kontaktierung für Sensoren **(4, 5)** angeordnet sind,
- die Sensoren **(4, 5)** unter einem Winkel auf einem Träger **(8)** bzw auf Trägern **(8)** zueinander dreidimensional auf der Grundplatte **(1)** angeordnet sind,
- die Kontaktstifte **(2)** ein gebogenes Ende **(3)** zur Schaffung von den Bondflecken **(9)** aufweisen, und
- das gebogene Ende **(3)** der Kontaktstifte **(2)** parallel zur Längsachse der Sensoren **(4, 5)** verläuft.

2. Vorrichtung nach Anspruch 1, **dadurch gekennzeichnet**, daß die Sensoren **(4, 5)** auf den Schenkeln eines metallischen Winkels **(8)** oder auf den Oberflächen eines Prismas in gewählten Winkeln als Träger zur Grundplatte **(1)** angeordnet sind.

3. Vorrichtung nach Anspruch 1, **dadurch gekennzeichnet**, daß die Bondflecken **(9)** unter einem Winkel von 45° zur Oberfläche der Grundplatte **(1)** angeordnet sind.

4. Vorrichtung nach Anspruch 1, **dadurch gekennzeichnet**, daß die Kontaktstifte **(2)** glasierte Durchführungen **(10)** durch die Grundplatte **(1)** aufweisen.

5. Vorrichtung nach Anspruch 1, **dadurch gekennzeichnet**, daß das Gehäuse **(6)** einen im wesentlichen rechteckigen Querschnitt aufweist.

6. Vorrichtung nach einem der vorangehenden Ansprüche, **dadurch gekennzeichnet**, daß die Sensoren **(4, 5)** als integrierte Hybridmodule ausgebildet sind.

## Claims

1. A device for packaging integrated circuits comprising sensors wherein
- in one single housing (6) there is arranged a planar base plate (1),
- contact pins (2) with bonding spots (9) for multi-polar contacting for sensors (4, 5) extend through the base plate (1)
- the sensors (4, 5) are arranged three-dimensionally at an angle on a carrier (8) or carriers (8) on the base plate (1),
- the contact pins (2) have a bent end (3) in order to provide the bonding spots (9) and
- the bent end (3) of the contact pins (2) extends in parallel to the longitudinal axis of the sensors (4, 5).

2. A device according to Claim 1, characterised in that the sensors (4, 5) are arranged on the legs of a metallic elbow (8) or on the surfaces of a prism as carrier at selected angles relative to the base plate (1).

3. A device according to Claim 1, characterised in that the bonding spots (9) are arranged at an angle of 45° relative to the surface of the base plate (1).

4. A device according to Claim 1, characterised in that the contact pins (2) comprise glazed bushings (10) extending through the base plate (1).

5. A device according to Claim 1, characterised in that the housing (6) has a substantially rectangular cross-section.

6. A device according to one of the preceding claims, characterised in that the sensors (4, 5) have the form of integrated hybrid modules.

## Revendications

1. Dispositif pour encapsuler des circuits intégrés, contenant des capteurs, dans lequel
- dans un unique boîtier (6) est disposée une plaque de base plane (1),
- à travers la plaque de base (1) sont disposés des broches de contact (2) avec pastilles de connexion (4) pour une connexion multipolaire pour des capteurs (4, 5),
- les capteurs (4, 5) sont disposés sur la plaque de base (1) en mode tridimensionnel, sous un certain angle l'un par rapport à l'autre, sur un support (8) ou sur des supports (8),
- les broches de contact (2) présentent une extrémité pliée (3) pour créer les pastilles de connexion (9), et
- l'extrémité pliée (3) des broches de contact (2) est orientée parallèlement à l'axe longitudinal des capteurs (4, 5).

2. Dispositif selon la revendication 1, caractérisé par le fait que les capteurs (4, 5) sont disposés sur les branches d'une équerre métallique (8) ou sur les faces d'un prisme, sous les angles choisis, comme support, par rapport à la plaque de base (1).

3. Dispositif selon la revendication 1, caractérisé par le fait que les pastilles de connexion (9) sont disposées sous un angle de 45° par rapport à la face supérieure de la plaque de base (1).

4. Dispositif selon la revendication 1, caractérisé par le fait que les broches de contact (2) présentent des traversées vitrifiées (10) à travers la plaque de base (1).

5. Dispositif selon la revendication 1, caractérisé par le fait que le boîtier (6) présente une section essentiellement rectangulaire.

6. Dispositif selon l'une des revendications précédentes, caractérisé par le fait que les capteurs (4, 5) sont conçus sous forme de modules hybrides intégrés.
